Europäisches Patentamt

European Patent Office

Office européen des brevets

(11) Publication number: **0 463 167 A1**

# EUROPEAN PATENT APPLICATION
## published in accordance with Art. 158(3) EPC

(21) Application number: 90913575.8

(22) Date of filing: **15.01.90**

(86) International application number:
**PCT/SU90/00007**

(87) International publication number:
**WO 91/10534 (25.07.91 91/17)**

(51) Int. Cl.⁵: **B23K 35/40**

(43) Date of publication of application:
**02.01.92 Bulletin 92/01**

(84) Designated Contracting States:
**AT CH DE FR GB IT LI SE**

(71) Applicant: **LENINGRADSKY POLITEKHNICHESKY INSTITUT IMENI M.I.KALININA**
**ul. Politekhnicheskaya 29**
**Leningrad, 195251(SU)**

(72) Inventor: **ERMAKOV, Sergei Alexandrovich**
**pr. Shvernika, 24-3-19**

**Leningrad, 194223(SU)**
Inventor: **KARASEV, Mikhail Valentinovich**
**ul. Simonova, 7-2-58**
**Leningrad, 194358(SU)**
Inventor: **KLUBNIKIN, Valery Stepanovich**
**ul. Moiseenko, 8b-20**
**Leningrad, 193144(SU)**

(74) Representative: **Patentanwälte Zellentin & Partner**
**Zweibrückenstrasse 15**
**W-8000 München 2(DE)**

(54) **METHOD OF MAKING ELECTRODE.**

(57) To make an electrode (5) an insert (7) of the electrode (5) is placed into its housing (6) and the electrode (5) is subjected to thermal treatment through heating and cooling. The electrode (5) is heated up to the temperature of eutectic interaction between the materials of the insert (7) and the housing (6), and cooling of the electrode, starting from the moment of eutectic interaction, is effected at a speed which is no less than 35 °C/sec.

Field of the Invention

The present invention relates to the field of electro-plasma technology and engineering or, more specifically, to methods used to manufacture electrodes for electric-arc plasmatrons (plasma guns). Primarily, the invention relates to methods used to produce thermochemical electrodes which can be employed as cathodes in electric-arc plasmatrons. The invention can be utilized by all branches of the national economy to increase the service life of electrodes used in electric-arc plasmatrons designed for welding, cutting, spray coating, and other technological processes.

Prior Art

Normally, electrodes used as cathodes in electric-arc plasmatrons (plasma guns) comprise a cooled sleeve and a high-melting core inserted into said sleeve. The materials that can be used for thermochemical electrode cores include a wide range of metals, namely zirconium, hafnium, titanium, and others, while copper is generally used as sleeve material. The service life is longest in electrodes with cores fabricated from zirconium-or hafnium-based materials. However said metals have relatively low thermal conductivity. The service life of thermochemical electrodes is therefore largely dependent on the intensity of cooling provided, specifically, on the intensity of cooling of their cores. Improving the thermal contact between the core and the sleeve is one of the directions for enhancing the intensity of cooling.

A variety of known methods are available for securing a core within a sleeve, such as by using a lathe or by pressing the core into the sleeve (D.G.Bykhovsky, Plasmennaya rezka, 1972, Mashinostroenie, (Leningrad), p.167). These types of methods designed for securing a core within a sleeve rely solely upon a mechanical contact between core and sleeve, without any chemical or other stronger bond formed therebetween in the contact zone. Considering that completely smooth contacting core and sleeve surfaces cannot be obtained in electrodes manufactured by said methods, there exist contact microdiscontinuities between the core and sleeve surfaces. Said contact microdiscontinuities tend to increase the heat resistance in the contact zone, reducing the intensity of core cooling. In the process of plasmatron operation, the core and sleeve surfaces tend to oxidize in the contact discontinuity areas. The oxide film likewise increases the heat resistance in the contact zone. Besides, because of the effect produced by multiple thermal stresses resulting from periodic arcing and electrode cooling, there is a tendency for said microdiscontinuities to increase in size, with gaps forming between the contacting core and sleeve surfaces to still further increase the heat resistance in the contact zone. This will reduce the intensity of core cooling, the core may become overheated, and the electrode may fail in a short time. Electrode heating is resorted to in order to improve the heat contact between the contacting core and sleeve surfaces. There is known a method for electrode manufacturing, comprising the steps of inserting the electrode core into the axial hole of the electrode sleeve, compressing the sleeve around the core by drawing the core and sleeve assembly through a die, and effecting a heat treatment of the electrode by heating it and subsequently cooling (GB, A, 1523659). Electrode heating is performed up to a temperature of 650 to 750ºC, and cooling is performed under natural conditions, at ambient temperature. Drawing the electrode through a die provides a mechanical contact between the surfaces of the core and sleeve, with microdiscontinuities occurring in the contact between said surfaces, just as in the technical solution previously described. As the electrode is heated to a temperature of 650 to 750ºC, diffusion welding occurs between the core and sleeve materials at the points of contact. Diffusion welding serves to improve the heat contact between the core and sleeve due to the formation therebetween of a chemical bond (specifically, for Cu - Zr, Cu - Ti, and other systems). However, when the electrode is heated to a temperature within the range as stated above, diffusion welding takes place at the points of direct contact between the core and sleeve materials only. No diffusion welding occurs in the areas of microdiscontinuities that remain after the electrode has been drawn through the die. That is to say, contact microdiscontinuities remain, although diffusion welding at points of contact prevents their size from increasing in the process of plasmatron operation. As stated in connection with the previous technical solution, microdiscontinuities tend to increase the heat resistance in the contact zone, reducing the intensity of the core cooling. Elimination of microdiscontinuities may be obtained by increasing the electrode heating temperature or by increasing the electrode heat treatment time. However, as shown by investigations, diffusion welding of, e.g., a zirconium core of 5 mm diameter with a copper sleeve for a period of 2 hours at a temperature above 847ºC will completely convert the central part of the electrode to an intermetallic compound, and even under optimum welding conditions the intermetallic layer at the interface of the contacting surfaces is quite considerable. (M.F.Zhukov et al., Termokhimicheskie katody. Thermal Physics Institute, Sibirian Division, USSR Academy of Sciences, Novosibirsk, 1985, p.47). The explanation lies in the fact that the thickness of the intermetallic layer depends largely upon the time the electrode remains in the region of high temperatures, and, being a lengthy process, diffusion welding makes this layer a considerably thick one. Besides, cooling the electrode under natural conditions, at ambient temperature, takes a long time, and this also contributes to the thickness of the intermetallic layer. The intermetallic layer at the core-to-sleeve interface provides for a reliable core-to-sleeve union by chemical bonding which is stronger than mechanical engagement. However this layer will generally lead to higher thermal resistance in the contact zone. This is due to the intermetallics formed of the materials of thermochemical electrodes (those of cores and sleeves)having poorer properties as compared to the core material as such. Specifically, intermetallics have lower heat conductivity. Increasing the heat resistance of the core-to-sleeve contact zone may lead to the core overheating and the electrode sustaining a failure. In other words, electrodes manufactured accoring to this method do not have a long useful life either.

Besides, the temperature, at which the core and sleeve are subject to diffusion welding, determines in a large measure the productivity of the method. Specifically, at low temperatures (below 700°C), when the formation rate of intermetallics is not high, the time required for the diffusion welding process to eliminate microdiscontinuities runs into tens of hours, reducing the productivity of the method. With the temperature increasing, the diffusion welding time decreases (S.M.Gurevich, Spravochnik po svarke tsvetnykh metallov, 1981, Naukova Dumka (Kiev), p.500). However, as previously stated, the intermetallic layer at the core-to-sleeve interface in this case will be quite considerable.

Disclosure of the Invention

The present invention is based upon the objective of providing a method for manufacturing electrodes, wherein the electrode would be heated to a temperature, and cooling would be effected under conditions, such that, with the core and sleeve being reliably joined by chemical bonding between their materials all over their contacting surfaces, the heat resistance in the contact zone could be reduced, and the intensity of core cooling thereby enhanced, increasing the useful life of the electrode accordingly and raising the productivity of the method at the same time.

The objective as stated above is achieved by providing a method for manufacturing electrodes, wherein the electrode core is inserted into the electrode sleeve, and heat treatment is effected by heating and cooling the electrode, in which method, in accordance with the invention, the electrode is heated to a temperature permitting eutectic interaction between the core and sleeve materials, and the electrode cooling is effected from the starting point of eutectic interaction at a rate of at least 35°C per second.

When an electrode is heated to a temperature affording eutectic interaction between the core and sleeve materials, a reaction takes place in their contact zone, resulting in a liquid layer of eutectically interacting materials forming all over the contacting core and sleeve surfaces. Said interlayer comprises primarily intermetallics formed of the core and sleeve materials. It has been established by the inventors experimentally that immediately after the electrode has been heated to the eutectic interaction temperature, the thickness of the interlayer is between 20 and 50 $\mu$m, increasing exponentially with time. The inventors have also discovered that a long service life is assured for the electrode if the core and sleeve are joined by means of an intermetallic layer obtained as a result of an eutectic reaction, the thickness of said layer being 20 to 100 $\mu$m. The operating time for such electrodes amounts to 26 to 42 hours, which serves to increase the useful life of known electrodes manufactured, e.g., according to the method described in GB, A, 1523659. It is the opinion of the inventors that this is due to a reliable union, by chemical bonding, between the core and sleeve materials throughout their contacting surfaces, as well as relatively low heat resistance in the contact zone, being both assured when the intermetallic layer is within 20 to 100 $\mu$m thick. It has been found by the inventors experimentally that cooling of the electrode immediately after the eutectic reaction begins, at a rate of at least 35°C per second, permits of retaining the intermetallic layer thickness within 100 $\mu$m. Thus, heating the electrode to the eutectic interaction temperature, followed by cooling at a rate of at least 35°C per second, provides a good thermal contact between the core and sleeve increasing the service life of the electrode due to higher core cooling intensity.

Another point in favour of the proposed method is that the electrode manufacturing process takes a few seconds only, i.e. the productivity of this method is higher than that of the method according to GB, A, 1523659.

Brief Description of the Drawings

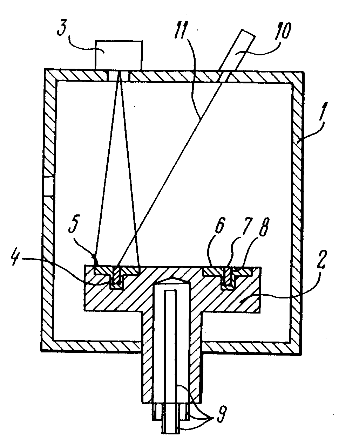

In the following, the invention is made more fully apparent through a detailed description of the best mode to carry out the invention with due references to the accompanying drawing which shows in cross section the device used to implement the proposed method. Since the proposed method of manufacturing of electrodes is realized with the use of the aforesaid device, the method is described along with the description of the operation of said device.

Best Mode to Carry out the Invention.

The device comprises a vacuum chamber 1 (FIG. ) connected with a roughing-down pump (not shown). Inside the chamber 1 there is a cooled disk 2 mounted for rotation, while at the top of the chamber 1 is installed an electron gun 3. Spaced around the periphery of the disk 2, at an equal distance from its axis, are provided holes 4 to accomodate electrodes 5. Each electrode 5 comprises a sleeve 6 and a core 7 inserted into the axial hole 8 of the sleeve 6. Connected to that part of the disk 2 taken outside of the vacuum chamber 1, are tubes 9 designed to supply and remove a cooling agent. Also installed outside of the vacuum chamber 1 is a pyrometer 10 to monitor the temperature of the electrode 5. The optical axis 11 of the pyrometer 10 is oriented towards the core surface.

According to the invention, the electrode manufacturing process is realized as follows. The core 7 is inserted into the axial hole 8 of the sleeve 6, and a mechanical contact is provided between the core 7 and sleeve 6 using any known method, e.g. by drawing the core-and-sleeve assembly through a die. The sleeve 6 and the core 7 are made of materials which react eutectically when heated (Spravochnik po paike, Ed. S.N. Lotsmanov, 1975, Mashinostroenie (Moscow), p.274). Besides, the material of the core 7 must meet the requirements for thermochemical cathodes (M.V. Zhukov et al.. Termokhimicheskie katody, Institute of Thermal Physics, Siberian Division, USSR Academy, of Sciences, 1985, p.5). Specifically, the sleeve 6 is generally made of copper while a wide range of metals, e.g. zirconium, hafnium, and titanium, may be used as materials for the core 7. Assembled electrodes 5 are placed into the holes 4 in the disk 2, one of the electrodes 5 being located opposite the electron gun 3. Vacuum is produced and maintained in the chamber 1, with a residual gas pressure not exceeding 0.1 Pa. The electron gun 3 is turned on to heat the surface of the electrode 5 facing said gun 3. The power rating of the electron gun 3 is determined by a known method, based on the eutectic interaction temperature specific to the pair of materials selected for the core 7 and sleeve 6 of the electrode 5 and on the dimensions of the electrode 5. The eutectic interaction temperature specific to the materials used in the electrode 5 is determined from the known constitutional diagrams for metallic systems. Thus, for copper - zirconium or copper - hafnium systems, the eutectic interaction temperature is 950°C (Diagramma sostoyania metallicheskikh sistem, 1976, VINITI (Moscow), p.44). The surface of the electrode 5 is heated until eutectic reaction begins between the materials of the core 7 and sleeve 6. For each configuration of the electrode 5 and each quality of mechanical contact between the core (insert) 7 and the sleeve (holder) 6, the starting point of eutectic reaction is determined experimentally. This is achieved by varying the heating time for test electrodes 5 of similar configuration and with similar mechanical contact in the vacuum chamber 1 at the eutectic interaction temperature specific to the materials of the core 7 and sleeve 6 and by determining the thickness of the interaction zone for various heating ranges. It has been established by the inventors experimentally that the thickness of said zone corresponding to the beginning of eutectic interaction is within 20 to 50 $\mu$m. Such is the method used to determine the heating time in the vacuum chamber 1 for the electrode 5 in the manufacturing process. The temperature of the electrode 5 being heated in the vacuum chamber 1 is monitored by means of the pyrometer 10. The inventors have found experimentally that the heating time for electrodes of various dimensions and configurations before the beginning of eutectic interaction does not exceed 5 seconds, which provides for the high productivity of the proposed method. As the electrode 5 is heated to the eutectic interaction temperature specific to the materials of the core 7 and sleeve 6, a reaction takes place in the core-to-sleeve contact zone, resulting in the formation of a liquid interlayer of eutectically intermetallics formed of the materials of the core 7 and sleeve 6. As previously mentionned, the inventors have discovered that after heating the electrode 5 to the temperature of eutectic interaction of the electrode materials and after the beginning of this interaction, the thickness of the interlayer amounts to 20 - 50 $\mu$m. Said thickness of the interlayer zone assures a reliable contact between the core and sleeve, with the advantage of the contact zone having a relatively low heat resistance, this providing a long service life for the electrode 5. After reaching the eutectic interaction temperature specific for the materials of the core 7 and sleeve 6 at their interface and after the beginning of eutectic interaction, the disk 2 is rotated by a predetermined angle corresponding to the arrangement of electrodes 5, thereby removing the electrode 5 from the heating zone. Considering that the electrodes 5 are located in the holes 4 provided in the water-cooled disk 2, they are rapidly cooled after the beginning of eutectic interaction. The cooling rate is maintained at a minimum of 35°C per second. A fixed cooling rate is assured by supplying the necessary quantity of cooling agent at the specified temperature through the tubes 9. The quantity of cooling agent, e.g. water, and the temperature thereof are determined by known methods, e.g.

by using rotameters and thermocouples (not shown). Owing to the electrode 5 being cooled at a rate of at least 35°C per second, the thickness of the interlayer resulting from the eutectic interaction of the materials of the electrode 5 does not exceed 100 $\mu$m. It has been established by the inventors experimentally that at this thickness of the intermetallic layer the heat resistance of the contact zone is likewise comparatively low, assuring a long sevice life for the electrode 5. After the treatment of all electrodes 5 accomodated in the disk 2 is completed, the vacuum system is isolated, and the finished electrodes 5 are removed.

The device as described above has been used to produce several electrodes using various materials and various heat treatment modes. Cited below are examples of various mode parameters that can be used to implement the proposed method and of the characteristics of the electrodes 5 manufactured in accordance with said parameters. In all test runs, the vacuum in the chamber 1 was maintained with the range of 0.01 to 0.05 Pa. In each example, three identical electrodes 5 were produced under the same heat treatment conditions.

Example 1

Three identical electrodes 5 were produced, with cores 7 made of zirconium, and sleeves 6 of copper. The temperature of eutectic interaction of the Zirconium - copper pair was 950°C. The electrodes 5 were heated to 750°C, the same temperature as used for heating electrodes in the known method according to GB, A, 1523659. The holding time for the electrode at this temperature was 1 hour. The rate of electrode cooling after the heating period was maintained at 38°C per second. The metallographic analysis of the core 7 - sleeve 6 interface revealed the interface to be discontinuous in all the three electrodes 5, showing that there had been no eutectic reaction. The electrodes 5 thus obtained were used in a plasmatron for testing them in operation for a period of one hour. The test results were used to determine the specific erosion of the electrodes 5 which was calculated from the relation

$$G = \frac{\Delta m}{It}$$

where:

$\Delta m$     is the change in the weight of the core 7 during 1 hour of the plasmatron operation, g;

I ,     arc current, A; and

t ,     arcing time, s.

The specific erosion was $(1...4) \cdot 10^{-8}$ g/C at 200 to 220 A arc current. The specific erosion values obtained were used to calculate the service life of each electrode 5 using the following relationship:

$$R = \frac{m}{I \cdot G \cdot 3600}$$

where:

m,     core weight, g;

I,     arc current, A; and

G,     specific erosion of electrode 5, g/C.

The useful life of electrodes 5 was found to be 5...20 hours.

Example 2

The material of the core 7 was hafnium that of the sleeve 6 copper. The electrodes 5 were heated to 950°C, which corresponded to the eutectic interaction temperature specific for the materials selected for the core 7 and sleeve 6. The heating time for the electrodes 5 prior to the beginning of the eutectic reaction was 5 s. Starting from the beginning of the eutectic reaction, the electrodes 5 were cooled, with the cooling rate maintained equal to 34°C per second. The metallographic analyses revealed that in all the three electrodes 5 the contact zone between the core 7 and the sleeve 6 is characterized by the presence of a eutectic interaction zone being 130 to 150 $\mu$m thick. After testing the electrodes 5 in operation in a plasmatron, the specific erosion of the electrodes 5 and their service life were calculated just as in the previous example, and these were found to be equal respectively to: $G = (4...6) \cdot 10^{-8}$ g/C and R = 3.5...5 hours.

Example 3

The material of the core 7 was zirconium, that of the sleeve 6 copper. The electrodes 5 were heated to 950°C which corresponded to the eutectic interaction temperature of said materials. The heating time prior to the beginning of the eutectic reaction was 5 s. The cooling rate for the electrodes 5 after the beginning of the eutectic reaction was maintained equal to 36°C per second. The metallographic analyses showed that the contact zone between the core 7 and the sleeve 6 was characterized for all the three electrodes 5 by the presence of a eutectic interaction zone being 70 to 90 $\mu$m thick. The specific erosion was $(6...8) \cdot 10^{-9}$ g/C, the service life was R = 26...35 hours.

Example 4

The material of the core 7 was hafnium, that of the sleeve 6 copper. The electrodes 5 were heated to 950°C which corresponded to the eutectic interaction temperature specific to said materials. The heating time was 5 s. The electrode cooling rate was maintained equal to 50°C per second.

The metallographic analyses revealed that in all the three electrodes 5 the contact zone between the core 7 and the sleeve 6 were characterized by the presence of an eutectic interaction zone being 50 to 70 $\mu$m thick. The specific erosion was $(5...6) \cdot 10^{-9}$ g/C, the useful life was 35...42 hours.

The heat treatment modes for the electrodes 5 and the characteristics of the electrodes 5 obtained are tabulated below.

Table

| Example | Heating temperature, °C | Heating time, s | Cooling rate, °C/s | Core-to-sleeve contact zone thickness, $\mu$m | Specific erosion, g/C | Service life, h |
|---|---|---|---|---|---|---|
| 1 | 750 | 3600 | 38 | 0 | $(1...4) \cdot 10^{-8}$ | 5...20 |
| 2 | 950 | 5 | 34 | 130...150 | $(4...6) \cdot 10^{-8}$ | 3.5...5 |
| 3 | 950 | 5 | 36 | 70... 90 | $(6...8) \cdot 10^{-9}$ | 26...35 |
| 4 | 950 | 5 | 50 | 50... 70 | $(5...6) \cdot 10^{-9}$ | 35...42 |

Cited in the table, for each example, are the value ranges for the contact zone between the core 7 and the sleeve 6, the specific erosion and the calculated service life for the three identical electrodes. The varying thickness values for the contact zone between the core 7 and the sleeve 6 in each example are due to the impossibility of providing a completely identical mechanical contact between the core 7 and the sleeve 6 prior to heat treatment. The spread of service life values for the electrodes 5 in each example is due to, firstly, the range of thickness values for the contact zone between the core 7 and the sleeve 6 and, secondary, the weighing error present in the weighing of electrodes after being tested in a plasmatron.

It can be seen from the tabulated data that the optimum heat treatment conditions for the electrodes 5 are those cited in Examples 3 and 4, where a long service life is achieved for the electrodes 5. Besides, the table shows that the manufacturing process for the electrodes 5 takes just several seconds, providing thereby a relatively high productivity for the method.

Industrial Applicability

The proposed method can be used to best advantage in the manufacture of thermochemical electrodes to be used as cathodes in electric-arc plasmatrons (plasma guns).

**Claims**

1. A method of manufacturing an electrode (5), wherein a core (7) of the electrode (5) is inserted into an electrode sleeve (6), and heat treatment is effected by heating and cooling the electrode (5), **characterized** in that the electrode (5) is heated to a temperature permitting eutectic interaction between the materials of the core (7) and the sleeve (6), and cooling of the electrode (5) is effected from the starting point of eutectic interaction at a rate of at least 35°C per second.

# INTERNATIONAL SEARCH REPORT

International Application No PCT/SU 90/00007

**I. CLASSIFICATION OF SUBJECT MATTER** (if several classification symbols apply, indicate all)

According to International Patent Classification (IPC) or to both National Classification and IPC

$IPC^5$     B23K 35/40

**II. FIELDS SEARCHED**

Minimum Documentation Searched

| Classification System | Classification Symbols |
|---|---|
| $IPC^5$ | B23K 35/40, B21C 23/22, B23K 9/16, H05H 1/34, H05B 7/08, H05H 1/26, B23K 35/02, H01 L 35/34, B23K 35/10 |

Documentation Searched other than Minimum Documentation
to the Extent that such Documents are Included in the Fields Searched

**III. DOCUMENTS CONSIDERED TO BE RELEVANT**

| Category | Citation of Document, with indication, where appropriate, of the relevant passages | Relevant to Claim No. |
|---|---|---|
| A | DE, B2, 2610009 (INSTITUT ELEKTROSVARKI IMENI E.O.PATONA AKADEMII NAUK UKRAINSKOJ SSR), 30 October 1980 (30.10.80) | 1 |
| A | US, A, 3344506 (JACQUES ANDRE STOHR), 03 October 1967 (03.10.67) | 1 |
| A | SU, A1, 899194 (Kolchuginsky zavod po obrabotke tsvetnykh metallov im. Sergo Ordzhonikidze et al.), 28 January 1982 (28.01.82) | 1 |
| A | DE, A1, 3618600 (AGA AB), 12 November 1986 (12.11.86) | 1 |

* Special categories of cited documents:

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| 06 September 1990 (06.09.90) | 06 December 1990 (06.12.90) |

| International Searching Authority | Signature of Authorized Officer |
|---|---|
| ISA/SU | |

Form PCT ISA/210 (second sheet) (January 1985)